# FASCICULE DE BREVET EUROPEEN

(11) **EP 3 740 768 B1**
(45) Date de publication et mention de la délivrance du brevet: **07.06.2023**
(21) Numéro de dépôt: 19705551.0
(22) Date de dépôt: 16.01.2019
(51) Int. Cl.: G01R 19/165, G01R 29/02

(54) **DISPOSITIF ÉLECTRONIQUE ÉQUIPÉ D'UNE FONCTION D'AUTO-DIAGNOSTIC**
ELEKTRONISCHE VORRICHTUNG MIT SELBSTDIAGNOSEFUNKTION
ELECTRONIC DEVICE PROVIDED WITH A SELF-DIAGNOSIS FUNCTION

(30) Priorité: 18.01.2018 FR 1850402
(43) Date de publication de la demande: 25.11.2020
(73) Titulaire: Crouzet Automatismes, 26000 Valence (FR)
(72) Inventeur: STEMMELEN, Thomas, 26000 Valence (FR)
(74) Mandataire: INNOV-GROUP
(86) Numéro de dépôt international: PCT/FR2019/050085
(87) Numéro de publication internationale: WO 2019/141939

(56) Documents cités:
- US-A- 4 342 965
- US-A- 4 857 760
- US-A1- 2002 196 048

## Description

L'invention concerne un ensemble comportant un dispositif électronique équipé d'une fonction d'auto-diagnostic. L'invention concerne également :
- un module d'auto-diagnostic pour la réalisation de ce dispositif électronique,
- un procédé d'auto-diagnostic, et
- un support d'enregistrement pour la mise en oeuvre de ce procédé.

Des dispositifs électroniques connus équipés d'une fonction d'auto-diagnostic comportent :
- un générateur apte à générer sur une sortie un signal électrique discret pouvant uniquement prendre, à un instant donné, un seul état stable parmi un ensemble discret d'états stables possibles, cet ensemble discret étant choisi dans le groupe constitué d'un ensemble discret de plusieurs tensions stables et d'un ensemble discret de plusieurs intensités stables de courant, cet ensemble discret d'états stables possibles comportant un premier et un second états stables prédéterminés,
- un module d'auto-diagnostic apte à générer un signal d'erreur signalant une défaillance, ce module d'auto-diagnostic étant apte à générer ce signal d'erreur en étant uniquement connecté à la sortie du générateur.
Des détecteurs d'impulsions électriques très courtes sont également connus de US4857760A. Toutefois, ces détecteurs ne sont pas utilisés pour détecter et indiquer des signes avant-coureurs de défaillance.

Généralement, le générateur est formé de composants électroniques montés sur un circuit imprimé. Au cours du temps, les composants électroniques et le circuit imprimé sont soumis à de nombreuses sollicitations extérieures telles que des sollicitations thermiques et mécaniques. Ces sollicitations extérieures finissent par user les composants électroniques et les pistes électriques du circuit imprimé. Cette usure progressive des composants électroniques du circuit imprimé finit par entraîner une panne du générateur qui interrompt définitivement son fonctionnement. Le module d'auto-diagnostic permet de détecter cette panne définitive.

Toutefois, il serait préférable que le module d'auto-diagnostic soit capable de signaler une erreur avant même que la panne définitive du générateur n'intervienne. En effet, cela est souhaitable pour être capable de mettre en place des interventions de maintenance préventive, afin d'éviter que ce générateur ne tombe définitivement en panne. De plus, un tel module d'auto-diagnostic doit rester simple à réaliser.

L'invention a donc pour objet un ensemble comportant un tel dispositif électronique conforme à la revendication 1.

Les modes de réalisation de cet ensemble peuvent comporter une ou plusieurs des caractéristiques des revendications dépendantes.

L'invention a également pour objet un procédé d'auto-diagnostic mis en œuvre par le dispositif électronique revendiqué.

Enfin, l'invention a également pour objet un support d'enregistrement d'informations lisible par un microprocesseur pour la mise en oeuvre du procédé revendiqué.

L'invention sera mieux comprise à la lecture de la description qui va suivre, donnée uniquement à titre d'exemple non limitatif et faite en se référant aux dessins sur lesquels :
- la figure 1 est une illustration schématique d'un dispositif électronique équipé d'une fonction d'auto-diagnostic ;
- la figure 2 est une illustration schématique d'un premier mode de réalisation d'un module d'auto-diagnostic pour le dispositif électronique de la figure 1 ;
- la figure 3 est un organigramme d'un procédé d'auto-diagnostic mis en oeuvre dans le dispositif électronique de la figure 1 ;
- les figures 4 et 5 sont des graphes illustrant l'évolution au cours du temps de différents signaux électriques du module d'auto-diagnostic de la figure 2 ;
- la figure 6 est une illustration schématique d'un autre mode de réalisation d'un dispositif électronique équipé d'une fonction d'auto-diagnostic ;
- la figure 7 est une illustration schématique d'un autre mode de réalisation du module d'auto-diagnostic de la figure 2.

### Chapitre I : Notations et définitions :

Dans les figures, les mêmes références sont utilisées pour désigner les mêmes éléments.

Dans la suite de cette description, les caractéristiques et les fonctions bien connues de l'homme du métier ne sont pas décrites en détail.

Un signal électrique « discret » est un signal électrique qui ne peut prendre, à un instant donné, qu'un seul état stable parmi un ensemble discret prédéterminé de plusieurs états stables possibles. Ce signal électrique discret peut prendre au cours du temps chacun des états stables de l'ensemble discret prédéterminé. Par contre, ce signal électrique discret ne peut pas prendre un état stable qui ne fait pas partie de cet ensemble discret prédéterminé. L'ensemble discret comporte un nombre borné et limité d'états stables possibles.

Par « état stable », on désigne une valeur du signal électrique discret qui peut être maintenue constante pendant une période de temps plus longue que le temps de transition δt nécessaire pour passer d'un état stable à un autre état stable. Par *« période plus longue »,* on désigne une période au moins deux fois, et de préférence dix fois ou cent fois, supérieure au temps δt. Par exemple, cette période est supérieure à 1 s ou 5 s ou 10 s ou 1 min.

Par « raccorder », on désigne le fait de raccorder électriquement.

Une « commutation intempestive » d'un signal électrique discret est un basculement accidentel d'un état stable initial de ce signal électrique discret vers un autre état suivi immédiatement d'un retour à cet état initial. Une commutation intempestive est très courte, c'est-à-dire que le basculement de l'état stable initial vers l'autre état puis le retour vers l'état stable initial se produit dans un intervalle Δc de temps très court. L'intervalle Δc est inférieur au plus petit intervalle Δmin de temps pendant lequel le signal électrique discret peut conserver un même état stable en absence de défaillance et lors d'un fonctionnement normal. Typiquement, l'intervalle Δc est inférieur à Δmin/2 ou inférieur à Δmin/10 ou Δmin/100. Typiquement, l'intervalle Δc est inférieur à 1 s et souvent inférieur à 500 µs ou 100 µs ou 50 µs.

Une « impulsion intempestive » est une commutation intempestive du signal électrique discret lors de laquelle l'état du signal électrique discret passe d'un état initial stable vers un état plus élevé avant de revenir à cet état initial stable. L'état plus élevé correspond à une valeur du signal électrique plus élevée que celle qu'il a dans l'état initial stable. L'état plus élevé peut être un autre état stable plus élevé ou un état instable plus élevé.

Ici par « état instable », on désigne un état du signal électrique discret qui n'appartient pas à l'ensemble discret prédéterminé des états stables possibles pour ce signal électrique discret.

Une « coupure intempestive » est une commutation intempestive du signal électrique discret lors de laquelle la valeur du signal électrique discret passe d'un état initial stable vers un autre état moins élevé avant de revenir à son état initial stable. L'état moins élevé correspond à une valeur du signal électrique moins élevée que celle qu'il a dans l'état initial stable. L'état moins élevé peut être un autre état stable moins élevé ou un état instable moins élevé. Typiquement, le plus souvent, dans l'état moins élevé la valeur du signal électrique discret est égale à 0 A ou à 0 Vdc.

### Chapitre II : Exemples de modes de réalisation :

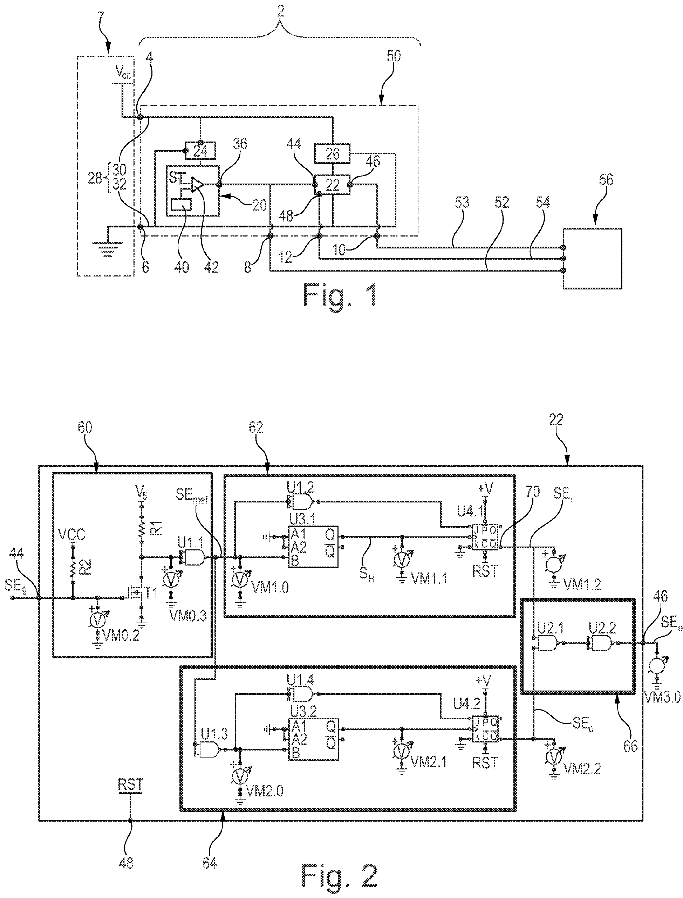

La figure 1 représente un dispositif électronique 2 d'un aéronef. L'aéronef est par exemple un avion ou un hélicoptère. Le dispositif 2 est équipé :
- de deux bornes 4 et 6 destinées à être raccordées à une source 7 d'alimentation électrique,
- d'une sortie 8 par laquelle est émis un signal électrique discret SE_{g},
- d'une sortie 10 par laquelle est émis un signal de diagnostic discret SEₑ qui permet de signaler une erreur à partir de l'analyse du signal SE_{g}, et
- une entrée 12 pour recevoir une commande de réinitialisation.

Sur la figure 1, seul le potentiel Vcc et la masse (0 Vdc) de la source 7 sont représentés. Le potentiel Vcc est une tension continue. Elle est par exemple comprise entre 3 Vdc et 30 Vdc ou entre 3 Vdc et 50 Vdc. Ici, le potentiel Vcc est égal à 30 Vdc. La source 7 est par exemple un réseau de distribution d'électricité ou une batterie.

La borne 4 est raccordée au potentiel Vcc et la borne 6 est raccordée à la masse.

Dans ce mode de réalisation, le signal SE_{g} ne peut prendre que deux états stables. Ces deux états stables sont appelés par la suite, respectivement, « état V₀ » et « état V₃₀». Dans les états V₀ et V₃₀ les valeurs du signal SE_{g} sont égales, respectivement, à 0 Vdc et Vcc.

Le signal SEₑ est aussi un signal électrique discret. Dans ce mode de réalisation, il prend uniquement que deux états stables V₀ et V₅. L'état V₀ du signal SEₑ est le même que l'état V₀ du signal SE_{g}. Dans l'état V₅, la valeur du signal SEₑ est égale à 5 Vdc. En l'absence de défaillance, le signal SEₑ est dans l'état V₅. Pour signaler une erreur, le signal SEₑ est dans l'état V₀.

Pour générer les signaux SE_{g} et SEₑ, le dispositif 2 comporte, respectivement, un générateur 20 et un module 22 d'auto-diagnostic. Le dispositif 2 comporte également un étage 24 d'alimentation du générateur 20 et un étage 26 d'alimentation du module 22 ainsi qu'un bus 28 d'alimentation.

Le bus 28 comporte deux conducteurs électriques 30 et 32 raccordés directement et en permanence, respectivement, aux bornes 4 et 6.

L'étage 24 est raccordé aux conducteurs 30 et 32 et produit, à partir de la différence de potentiels entre les bornes 4 et 6, la tension et le courant nécessaires pour alimenter et faire fonctionner le générateur 20. L'étage 24 permet de stabiliser l'alimentation du générateur 20 et, si nécessaire, de délivrer une tension d'alimentation au générateur 20 supérieure ou inférieure au potentiel Vcc. À cet effet, l'étage 24 comporte typiquement un circuit imprimé et des composants électroniques. L'étage 24 est donc susceptible de présenter des défaillances qui produisent des coupures intempestives de l'alimentation du générateur 20 et donc des coupures intempestives du signal SE_{g}.

Par exemple, l'étage 24 comporte une diode Zener et, éventuellement, un ou plusieurs condensateurs pour stabiliser l'alimentation du générateur 20. L'homme du métier sait comment réaliser un tel étage d'alimentation. Par conséquent, l'étage 24 n'est pas décrit ici plus en détail.

L'étage 26 remplit les mêmes fonctions que l'étage 24 mais pour le module 22. Il est donc typiquement réalisé de la même manière que l'étage 24. Par conséquent, l'étage 26 n'est pas décrit ici plus en détail. L'étage 26 est distinct et indépendant de l'étage 24. En particulier, l'étage 26 peut fonctionner correctement même si l'étage 24 est défaillant. De plus, quelle que soit la défaillance qui affecte le fonctionnement de l'étage 24, celle-ci n'a aucune incidence sur le fonctionnement de l'étage 26. Pour cela, les étages 24 et 26 sont réalisés chacun à l'aide de leurs propres composants électroniques.

Le générateur 20 comporte une sortie 36 sur laquelle est émis le signal SE_{g}. Cette sortie 36 est directement raccordée à la sortie 8. Dans cet exemple, le générateur 20 est un détecteur d'une grandeur physique. Le signal SE_{g} est dans l'état V₃₀ lorsque la grandeur physique franchit, dans un sens, un seuil S₁ prédéterminé. Le signal SE_{g} est dans l'état V₀ lorsque cette grandeur physique franchit, dans le sens opposé, un seuil S₂ prédéterminé. Ici, pour simplifier la compréhension, les seuils S₁ et S₂ sont égaux de sorte que le générateur 20 ne présente pas d'hystérésis.

La grandeur physique détectée peut être de toute nature. Par exemple, et de manière non limitative, cette grandeur physique peut être :
- une grandeur physique électrique telle qu'une résistance électrique, une intensité d'un courant ou une tension,
- une grandeur physique mécanique telle qu'un déplacement mécanique d'une pièce,
- une grandeur physique magnétique telle que l'amplitude et/ou la direction d'un champ magnétique ou d'un champ électrique, et
- une grandeur physique optique telle que l'intensité lumineuse.

Le générateur 20 comporte typiquement un circuit imprimé et des composants électroniques. Ainsi, le générateur 20, comme l'étage 24, est susceptible de présenter des défaillances qui produisent des impulsions intempestives et des coupures intempestives du signal SE_{g}.

Pour générer le signal SE_{g}, à titre d'illustration, le générateur comporte :
- un transducteur 40 qui convertit la grandeur physique en un signal électrique continu représentatif de la valeur de cette grandeur physique, et
- un comparateur 42 qui compare le signal électrique continu au seuil S₁ pour générer le signal SE_{g}.

Le module 22 détecte une défaillance du dispositif 2 seulement à partir de l'analyse du signal SE_{g}. Ici, le module 22 est donc notamment capable de détecter une défaillance de l'étage 24 et du générateur 20. Pour cela, le module 22 détecte des commutations intempestives dans le signal SE_{g}. En effet, de telles commutations intempestives sont provoquées par l'usure des composants électroniques et des circuits imprimés et constituent des signes avant-coureurs d'une panne définitive.

Le module 22 comporte :
- une entrée 44 raccordée à la sortie 36 pour recevoir le signal SE_{g} à analyser,
- une sortie 46 par laquelle le signal SEₑ est émis, et
- une entrée 48 de réinitialisation du module 22.

La sortie 46 est directement raccordée à la sortie 10 du dispositif 2. L'entrée 48 est directement raccordée à l'entrée 12 du dispositif 2. Un mode de réalisation détaillé du module 22 est décrit en référence à la figure 2.

Ici, l'ensemble des circuits imprimés et des composants électroniques du dispositif 2 est logé à l'intérieur d'un même boîtier 50. Le boîtier 50 est par exemple un boîtier étanche qui protège les composants électroniques contre la poussière et l'eau. Typiquement, l'indice de protection du boîtier 50 est égal ou meilleur que l'indice IP51 ou IP62. Ici, à titre d'illustration, les composants électroniques du générateur 20, du module 22 et des étages 24 et 26 sont montés sur le même circuit imprimé.

La figure 1 montre que les sorties 8 et 10 et l'entrée 12 sont raccordées par des liaisons filaires, respectivement 52 à 54, à des entrées et sortie respectives d'un système électronique 56 de traitement des signaux SE_{g} et SEₑ. Par exemple, le système 56 est capable, à partir du signal SE_{g}, de produire des commandes d'autres organes électriques de l'aéronef. Le système 56 est aussi capable de prendre en compte le signal SEₑ lors de la construction des commandes des autres organes de l'aéronef. Par exemple, le système 56 détermine à partir du signal SEₑ si le signal SE_{g} est fiable ou pas et dans le cas où le signal SE_{g} est considéré comme n'étant pas fiable, celui-ci est ignoré pour construire les commandes d'autres organes de l'aéronef. Le système 56 exploite aussi le signal SEₑ pour indiquer à un opérateur de maintenance que le générateur 20 et/ou l'étage 24 présentent des signes avant-coureurs de défaillance.

Le système 56 est également capable d'envoyer une commande d'initialisation au module 22 par l'intermédiaire de la liaison 54 et des entrées 12 et 48. Par exemple, cette possibilité est exploitée pour réinitialiser le module 22 après qu'il ait détecté une commutation intempestive sans avoir pour cela à couper l'alimentation du module 22. Après avoir été réinitialisé, le module 22 est de nouveau capable de détecter une nouvelle commutation intempestive.

La figure 2 représente un mode de réalisation du module 22. Le module 22 comporte :
- un étage 60 de mise en forme du signal SE_{g},
- un étage 62 de détection d'une impulsion intempestive,
- un étage 64 de détection d'une coupure intempestive, et
- un étage 66 de génération du signal SEₑ.

L'étage 60 transforme le signal SE_{g} en signal électrique SE_{mef} mis en forme. Ici, le signal SE_{mef} est identique au signal SE_{g} sauf que ses deux états stables sont, respectivement, les états V₀ et V₅ au lieu des états V₀ et V₃₀. De plus, la mise en forme consiste aussi à obtenir un signal SE_{mef} dont les fronts montants et descendants sont les plus verticaux possible.

Ici, l'étage 60 comporte :
- une résistance R2 raccordée entre l'entrée 44 et le potentiel Vcc, et
- un transistor MOSFET (transistor à effet de champ à grille isolée) T1, dont la grille est directement raccordée à l'entrée 44.

La source du transistor T1 est raccordée à la masse et son drain est raccordé à un potentiel 5 Vdc par l'intermédiaire d'une résistance R1.

Le drain du transistor T1 est également raccordé à un inverseur U1.1 dont la sortie délivre le signal SE_{mef}.

Le transistor T1 est passant si la tension V_{GS} entre sa grille et sa source est supérieure à un seuil prédéterminé V_{TH}. À l'inverse, si la tension V_{GS} est inférieure à ce seuil V_{TH}, le transistor T1 est non passant. Lorsque le transistor T1 est passant, le courant peut le traverser en allant du drain vers sa source.

L'étage 62 génère un signal électrique SEᵢ qui est dans l'état V₅ tant qu'aucune impulsion intempestive n'a été détectée. Dès qu'une impulsion intempestive est détectée dans le signal SE_{g}, l'étage 62 signale une erreur en basculant immédiatement le signal SEᵢ vers son état stable V₀

À cet effet, l'étage 62 comporte une bascule monostable U3.1 dont une entrée B est directement raccordée à la sortie de l'inverseur U1.1. Cette bascule U3.1 comporte également une sortie Q sur laquelle est émis un signal d'horloge S_{H}. Le signal S_{H} est un signal électrique discret qui peut seulement prendre les deux états stables V₀ et V₅. Le signal S_{H} prend l'état V₀ tant que le signal SE_{mef} ne présente pas un front montant. En réponse à un front montant dans le signal SE_{mef}, le signal S_{H} bascule de l'état V₀ vers l'état V₅ puis reste dans l'état V₅ pendant un intervalle de temps Δ3.1. Lorsque l'intervalle Δ3.1 est écoulé, le signal S_{H} retombe automatiquement et systématiquement à l'état V₀.

Ici, la bascule U3.1 est une bascule monostable non re-déclenchable ou non ré-armable. Ainsi, après avoir été déclenchée par un premier front montant du signal SE_{mef}, même si un deuxième front montant se produit dans le signal SE_{mef} avant la fin de l'intervalle Δ3.1, l'instant auquel le signale S_{H} retombe dans l'état V₀ demeure inchangé.

L'intervalle Δ3.1 est supérieur à l'intervalle Δc d'une impulsion intempestive, c'est-à-dire supérieur à la durée maximale d'une impulsion intempestive. Par exemple, ici, l'intervalle Δ3.1 est supérieur à 50 µs ou 100 µs. L'intervalle Δ3.1 est également inférieur à l'intervalle Δmin, c'est-à-dire inférieur à la durée minimale pendant laquelle le signal électrique SE_{g} conserve son état V₃₀. Ici, l'intervalle Δ3.1 est inférieur à 1 s. Par exemple, l'intervalle Δ3.1 est égal à 100 µs.

L'étage 62 comporte aussi une bascule U4.1. La bascule U4.1 est une bascule JK. L'entrée J de la bascule U4.1 est raccordée à la sortie de l'inverseur U1.1 par l'intermédiaire d'un inverseur U1.2. L'entrée K est raccordée à la masse. L'entrée du signal d'horloge de la bascule U4.1 est directement raccordée à la sortie Q de la bascule U3.1 pour recevoir le signal S_{H}. La bascule U4.1 comporte aussi une entrée RST qui est raccordée à l'entrée 48. Cette entrée RST permet de réinitialiser la bascule U4.1 et donc de détecter une nouvelle impulsion intempestive.

La bascule U4.1 comporte une sortie 70 par laquelle est émis le signal SEᵢ.

En réponse à un front descendant dans le signal S_{H}, la bascule U4.1 compare l'état actuel du signal électrique reçue sur son entrée J à l'état actuel reçue sur son entrée K. Si à cet instant, les états actuels sur les entrées J et K sont, respectivement, les états V₅ et V₀, alors la sortie 70 bascule vers l'état V₀. À l'inverse, si à cet instant les états actuels sur les entrées J et K sont tous les deux égaux à l'état V₀, alors la sortie 70 conserve sa précédente valeur. La bascule U4.1 est donc capable de mémoriser la détection d'une impulsion intempestive jusqu'à ce qu'elle soit réinitialisée.

À la mise sous tension ou suite à une commande de réinitialisation reçue sur son entrée RST, la sortie 70 bascule vers l'état V₅. Ainsi, tant que l'étage 62 n'a pas détecté une impulsion intempestive, le signal SEᵢ est dans l'état V₅. Dès qu'une impulsion intempestive est détectée, l'état du signal SEᵢ bascule vers l'état V₀ et reste dans cette état V₀ jusqu'à la prochaine mise sous tension ou jusqu'à la réception d'une commande de réinitialisation.

L'étage 64 génère un signal SE_{c} dans l'état V₅ tant qu'aucune coupure intempestive n'a été détectée. Si une coupure intempestive est détectée, l'étage 64 signale cette erreur en basculant immédiatement le signal SE_{c} dans son état V₀. Dans ce mode de réalisation, l'étage 64 est identique à l'étage 62 sauf qu'il comporte un inverseur supplémentaire U1.3 qui inverse le signal SE_{mef} avant qu'il soit transmis à la bascule monostable et à la bascule JK. Dans l'étage 64, la bascule U3.1, la bascule U4.1 et l'inverseur U1.2 portent, respectivement, les références numériques U3.2, U4.2 et U1.4. L'entrée de l'inverseur U1.3 est directement raccordée à la sortie de l'inverseur U1.1 et sa sortie est directement raccordée à l'entrée B de la bascule U3.2 et à l'entrée de l'inverseur U1.4. L'intervalle Δ3.1 est appelé « intervalle Δ3.2 » dans le cas de l'étage 64. Ici, les intervalles Δ3.1 et Δ3.2 sont égaux.

L'étage 66 génère le signal électrique SEₑ à partir des signaux électriques SEᵢ et SE_{c}. Plus précisément, l'étage 66 bascule le signal SEₑ dans l'état V₀ dès qu'au moins une impulsion intempestive ou une coupure intempestive a été détectée dans le signal SE_{g}. Pour cela, l'étage 66 comporte une porte logique U2.1 qui génère en sortie un signal qui correspond à l'opération logique « NON - ET » entre les signaux SEᵢ et SE_{c}. La sortie de la porte U2.1 est raccordée à la sortie 46 par l'intermédiaire d'un inverseur U2.2.

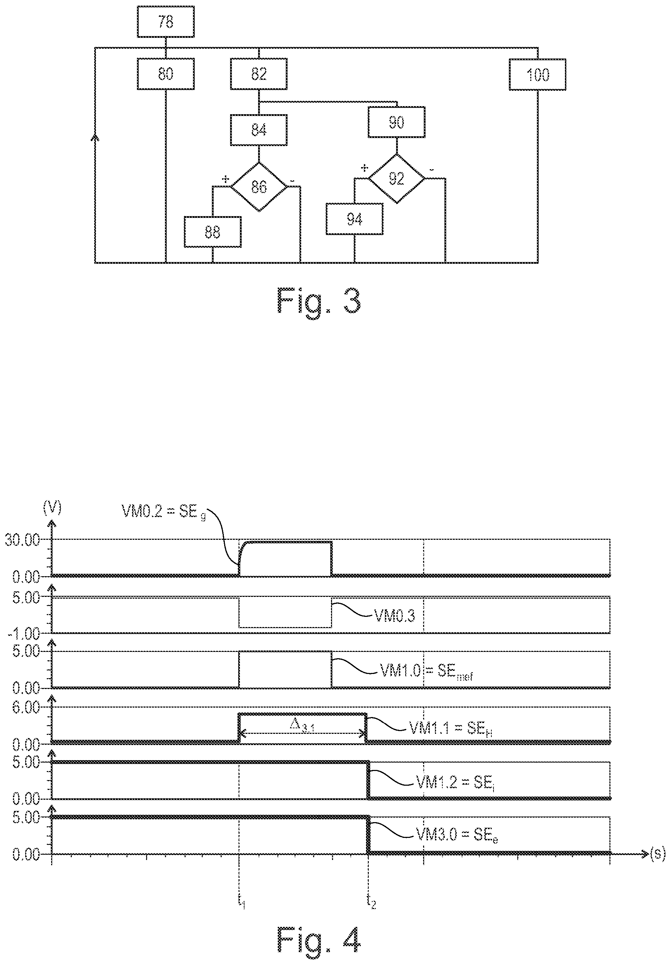

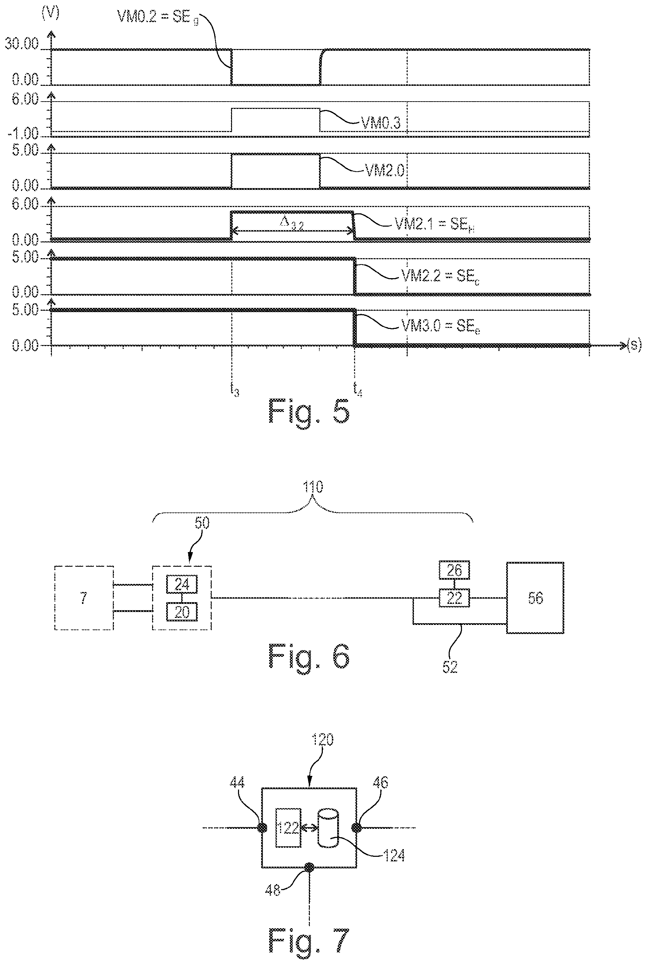

Sur la figure 2, les voltmètres VM0.2, VM0.3, VM1.0, VM1.1, VM1.2, VM2.0, VM2.1, VM2.2 et VM3.3 représentent les emplacements où sont mesurées les tensions portant les mêmes références numériques dans les graphes des figures 4 et 5. On notera que les tensions VM0.2, VM1.0, VM1.1, VM1.2, VM2.2 et VM3.0 correspondent, respectivement, aux signaux SE_{g}, SE_{mef}, S_{H}, SEᵢ, SE_{c} et SEₑ.

Le fonctionnement du dispositif 2 va maintenant être décrit à l'aide de la figure 3 et des graphes des figures 4 et 5.

Sur les graphes des figures 4 et 5, l'axe des abscisses est gradué en secondes. L'axe des abscisses est commun aux différents signaux électriques représentés sur chacun des graphes. Les axes des ordonnées sont gradués en volts. Un axe respectif des ordonnées est associé à chaque signal électrique représenté. Les figures 4 et 5 correspondent aux cas où les signaux SE_{g} générés comportent, respectivement, une impulsion intempestive et une coupure intempestive. Les signaux électriques représentés sur ces figures correspondent à ceux mesurés par les voltmètres repérés sur la figure 2 à l'aide de la même référence numérique.

Initialement, une phase 78 d'initialisation est exécutée. Cette phase 78 est au moins exécutée lors de la mise sous tension du module 22. Lors de cette phase 78, les bascules U4.1 et U4.2 sont initialisées de sorte que les signaux SEᵢ et SE_{c} sont dans leurs états V₅.

Ensuite, lors d'une étape 80, le générateur 20 génère en permanence le signal SE_{g} en fonction de la grandeur physique mesurée.

En parallèle, lors d'une étape 82, le signal SE_{g} est acquis par le module 22 et mis en forme par l'étage 60. Le signal SE_{mef} est transmis aux étages 62 et 64 de détection.

Lors d'une étape 84, en réponse à un front montant dans le signal SE_{g}, l'étage 62 déclenche une minuterie qui décompte l'intervalle Δ3.1. Ici, c'est la bascule U3.1 qui remplit cette fonction de minuterie. Sur la figure 4, le déclenchement de la minuterie intervient à un instant t₁.

Ensuite, lors d'une étape 86, à l'issue de l'intervalle Δ3.1, c'est-à-dire sur la figure 4 à un instant t₂, l'étage 62 compare l'état actuel du signal SE_{g} à son état initial, c'est-à-dire ici à l'état V₀. Cette comparaison est ici réalisée par la bascule U4.1.

Si à l'instant t₂, le signal SE_{g} est dans l'état V₀, cela signifie qu'il s'agit d'une impulsion intempestive. Dans ce cas, lors d'une étape 88, la bascule U4.1 fait basculer sa sortie 70 vers l'état V₀. En réponse, toujours lors de l'étape 88, le signal SEₑ bascule également vers l'état V₀ pour signaler la présence de cette impulsion intempestive et donc cette défaillance au système 56 de traitement.

À l'inverse, si à l'instant t₂, l'état actuel du signal SE_{g} est l'état V₅, et donc différent de l'état V₀, cela signifie qu'il ne s'agit pas d'une impulsion intempestive mais d'un changement d'état du signal SE_{g}. Dans ce cas, l'état du signal SEᵢ reste inchangé. Donc, si aucune impulsion intempestive n'a été signalée jusqu'à présent, le signal SEᵢ reste dans l'état V₅. Par contre, si une impulsion intempestive a déjà été détectée, le signal SEᵢ reste dans l'état V₀.

Les étapes 82 à 88 sont réitérées en boucle.

En parallèle des étapes 84 à 88, lors d'une étape 90, en réponse à un front descendant dans le signal SE_{g}, l'étage 64 déclenche une minuterie qui décompte l'intervalle Δ3.2. Ici, c'est la bascule U3.2 qui remplit cette fonction de minuterie. Sur la figure 5, le déclenchement de la minuterie intervient à l'instant t₃.

Lors d'une étape 92, à l'issue de l'intervalle Δ3.2, c'est-à-dire sur la figure 5 à l'instant t₄, l'étage 64 compare l'état actuel du signal SE_{g} à son état initial, c'est-à-dire ici à l'état V₅. Cette comparaison est réalisée par la bascule U4.2.

Lors d'une étape 94, si à l'instant t₄, l'état actuel du signal SE_{g} est l'état V₅, cela signifie qu'il s'agit d'une coupure intempestive. Dans ce cas, en réponse, la bascule U4.2 fait basculer immédiatement sa sortie vers l'état V₀. En réponse, toujours lors de l'étape 94, le signal SEₑ bascule également vers l'état V₀ pour signaler la présence de cette coupure intempestive et donc cette défaillance au système 56.

À l'inverse, si à l'instant t₄, l'état actuel du signal SE_{g} est l'état V₀, et donc différent de l'état V₅, cela signifie qu'il ne s'agit pas d'une coupure intempestive mais d'un changement d'état du signal SE_{g}. Dans ce cas, l'état du signal SE_{g} reste inchangé. Donc, si aucune coupure intempestive n'a été signalée jusqu'à présent, le signal SE_{c} reste dans l'état V₅. Par contre, si une coupure intempestive a déjà été détectée, le signal SE_{c} reste dans l'état V₀.

Les étapes 90 à 94 sont réitérées en boucle.

En parallèle des étapes précédentes, lors d'une étape 100, le système 56 traite les signaux SE_{g} et SEₑ. Par exemple, le signal SE_{g} est utilisé pour commander un autre organe de l'aéronef et le signal SEₑ est utilisé pour signaler une défaillance du générateur 20 ou de l'étage 24 qui nécessite la mise en oeuvre d'une opération de maintenance préventive.

La figure 6 représente un dispositif électronique 110 équipé d'une fonction d'auto-diagnostic. Le dispositif 110 est identique au dispositif 2 sauf que le module 22 et l'étage 26 d'alimentation sont déportés à proximité du système 56 de traitement. Dans ce cas, le module 22 peut être très éloigné du générateur 20. Par exemple, le module 22 est situé à plus de 1 m ou 10 m du générateur 20. Dans ce mode de réalisation, le module 22 et l'étage 26 ne sont plus situés à l'intérieur du boîtier 50 mais en dehors de ce boîtier. Le module 22 est donc mécaniquement indépendant du générateur 20 dans ce mode de réalisation. Le module 22 peut également être placé dans le même boîtier que celui qui contient le système 56, voire même être réalisé sur le même circuit imprimé que le système 56. Dans ce mode de réalisation, le module 22 est en plus sensible à une défaillance dans la liaison filaire 52 qui relie le générateur 20 au système 56.

La figure 7 représente un module d'auto-diagnostic 120. Ce module 120 fonctionne comme le module 22, sauf qu'il est réalisé à l'aide d'un microprocesseur programmable 122 apte à exécuter des instructions enregistrées dans une mémoire 124. À cet effet, la mémoire 124 comporte les instructions nécessaires pour l'exécution des étapes 82 à 94 du procédé de la figure 3.

### Chapitre III : variantes :

### Variantes du module d'auto-diagnostic :

En variante, l'étage 60 est omis. Ceci est par exemple possible si le signal SE_{g} n'a pas besoin d'être mis en forme et peut directement être transmis aux étages 62 et 64 de détection. Par exemple, ici, l'étage 60 peut être omis si les deux états stables du signal SE_{g} sont les états V₀ et V₅.

Le rôle des fronts montant et descendant peut être inversé. Dans ce cas, le module d'auto-diagnostic doit être adapté en conséquence. Par exemple, la minuterie peut être déclenchée sur un front descendant au lieu d'un font montant. Dans ce cas, la bascule monostable U3.1 est remplacée par une bascule monostable déclenchée par un front descendant et un inverseur est introduit pour inverser seulement le signal électrique reçu sur l'entrée B de cette bascule monostable. De façon similaire, la comparaison réalisée par la bascule JK peut être déclenchée en réponse à un front montant et non pas en réponse à un front descendant. Dans ce cas, l'entrée du signal d'horloge de la bascule U4.1 est raccordée à la sortie *Q̅* de la bascule monostable U3.1.

En variante, le signal SE_{g} peut prendre plus de deux états stables différents. Par exemple, le signal SE_{g} prend plus de trois ou quatre ou cinq états stables différents. Dans ce cas, par exemple, l'étage de mise en forme est modifié pour convertir le signal SE_{g} qui prend plus de deux états stables en un signal électrique discret mis en forme SE_{mef} qui prend uniquement que deux étages stables. Par exemple, en réponse à un front montant dans le signal SE_{g}, le SE_{mef} passe de l'état V₀ à l'état V₅. En réponse à un front descendant dans le signal SE_{g}, le signal SE_{mef} passe de l'état V₅ à l'état V₀. Ensuite, ce signal SE_{mef} est traité par les étages 62 et 64 comme décrit précédemment.

Les entrées 12 et 48 et la liaison 54 peuvent être omises. Dans ce cas, le module 22 ne peut pas être automatiquement réinitialisé après sa mise sous tension par le système 56. Dès lors, si le module 22 a détecté une commutation intempestive, tant que l'alimentation du module 22 n'est pas coupée, le signal SEₑ signale en permanence cette défaillance même si depuis elle a disparu.

Dans un autre mode de réalisation, la bascule U3.1 ou U3.2 ou les deux peuvent être remplacées par des bascules monostables ré-armables ou redéclenchables. Dans ce cas, à chaque fois qu'un nouveau front montant se produit dans le signal SE_{mef}, la minuterie est réinitialisée et redéclenchée.

En variante, les intervalles Δ3.1 et Δ3.2 sont différents l'un de l'autre. Cela peut être utile si l'intervalle Δc d'une impulsion intempestive est différent de l'intervalle Δc d'une coupure intempestive.

Il est possible de simplifier le module 22 pour que celui-ci soit uniquement capable de détecter les impulsions intempestives ou uniquement capable de détecter les coupures intempestives. Par exemple, l'étage 64 et l'étage 66 sont omis et la sortie 70 est directement raccordée à la sortie 46. Dans ce cas, le module 22 est uniquement apte à détecter une impulsion intempestive.

Dans le cas du module 120, le signal SE_{g} peut être enregistré dans un fichier numérique. Ensuite, le fichier numérique est transmis et enregistré, par exemple, dans la mémoire 124. Plus tard, alors que le signal SE_{g} n'est plus généré par le générateur 20, le module 120 analyse ce fichier numérique comme décrit par exemple en référence à la figure 3 pour détecter les commutations intempestives.

### Variantes du générateur :

En variante, le générateur peut présenter une hystérésis. Pour cela, les seuils S₁ et S₂ précédemment décrits ont des valeurs différentes.

Le générateur 20 n'est pas nécessairement un détecteur d'une grandeur physique. Dans la pratique, le générateur 20 peut être n'importe quel circuit électronique qui génère sur une de ses sorties un signal électrique discret. Par exemple, le générateur peut être un modulateur de largeur d'impulsion. Dans ce cas, le signal SE_{g} est un signal électrique modulé selon le principe d'une modulation de largeur d'impulsion, également connue sous l'acronyme PWM (« Pulse Width Modulation »). Dans ce cas, la durée de l'intervalle Δ3.1 ou Δ3.2 est inférieure, et de préférence au moins deux fois inférieure, à la durée de la plus petite impulsion que peut générer ce modulateur. Dans un autre exemple, le générateur est une horloge et le signal SE_{g} est un signal électrique discret périodique qui comporte des fronts montants ou descendants périodiques.

Dans un autre exemple, le générateur est un détecteur de valeurs analogiques hors gamme. Par exemple, la gamme de valeurs autorisées pour le signal analogique est [Sb ; Sh]. Dans ce cas, le générateur comporte deux comparateurs qui comparent en permanence la valeur du signal analogique, respectivement, au seuil haut Sh et au seuil bas Sb. Dès que l'un de ces seuils est franchit, le générateur modifie l'état du signal SE_{g}.

Dans le cas où la grandeur physique est un déplacement mécanique d'une pièce, le transducteur 40 est par exemple un simple interrupteur déplacé par cette pièce entre un état ouvert dans lequel la résistance électrique du transducteur 40 prend une valeur R₁ et un état fermé dans lequel cette résistance électrique prend une valeur R₂ différente. Dans ce cas, le comparateur 42 peut être remplacé par une simple différence de potentiels appliquée entre les bornes de l'interrupteur et en raccordant la sortie 36 à l'une de ses bornes.

Si la grandeur physique à mesurer est une grandeur physique électrique, le transducteur 40 peut être omis.

Le signal SE_{g} peut aussi être un courant, fourni ou absorbé par le générateur. En particulier, le générateur peut faire varier l'intensité d'un courant absorbé entre deux états stables en modifiant, par exemple, sa résistance interne. Le générateur peut aussi comporter une source de courant apte à faire varier l'intensité du courant fourni entre deux états stables. Dans ces cas, chaque état stable correspond à une intensité différente de ce courant. Tout ce qui a été décrit ici s'applique aussi à un tel signal SE_{g}. Par exemple, pour cela, l'étage 60 de mise en forme convertit en plus l'intensité du signal SE_{g} en une tension correspondante avant de transmettre le signal SE_{mef} aux étages 62 et 64.

### Autres variantes :

En variante, l'étage d'alimentation est commun au générateur 20 et au module 22. Par exemple, l'étage 24 alimente aussi le module 22. Dans ce cas, l'étage 26 peut être omis.

Le dispositif électronique peut être installé et utilisé ailleurs que dans un aéronef. Par exemple, il peut aussi être installé à l'intérieur d'un véhicule automobile ou ferroviaire. Il peut aussi être installé dans des environnements fixes comme à l'intérieur d'une centrale nucléaire ou d'une résidence ou d'une usine.

### Chapitre IV : avantages :

Il a été observé par les inventeurs que l'usure des composants électroniques et du circuit imprimé est à l'origine de commutations intempestives dans le signal électrique généré par le générateur et cela généralement bien avant que ce générateur ne tombe définitivement en panne. De plus, étant donné que ces commutations intempestives du signal SE_{g} sont très courtes, elles passent souvent inaperçues et, généralement, ne perturbent pas le fonctionnement du système 56 de traitement.

Les modules d'auto-diagnostic décrits ici permettent de détecter ces commutations intempestives et de les signaler. Dès lors, il est possible de signaler une défaillance du générateur bien avant que celui-ci ne tombe définitivement en panne. De plus, le dispositif électronique est simple à réaliser car il utilise seulement une minuterie et un comparateur pour détecter une défaillance du générateur. En particulier, le module d'auto-diagnostic n'utilise pas d'intégrateur ou de dérivateur pour détecter une défaillance du générateur.

Enfin, contrairement à certains modules connus d'auto-diagnostic, les commutations intempestives détectées ici ne sont pas volontairement générées pour tester le bon fonctionnement du générateur. Le module d'auto-diagnostic est donc dépourvu de générateur de commutations intempestives et n'utilise pas de telles commutations intempestives volontairement générées.

Le fait d'utiliser un étage d'alimentation pour alimenter le générateur distinct de celui utilisé pour alimenter le module d'auto-diagnostic permet de détecter en plus des commutations intempestives provoquées par un vieillissement et une usure de l'étage 24. Par ailleurs, cela permet de disposer d'un bloc électronique, formé par le module d'auto-diagnostic et son étage alimentation, qui peut être embarqué ou déporté.

## Revendications

1. Ensemble comportant :
- un dispositif électronique équipé d'une fonction d'auto-diagnostic, ce dispositif comportant :
- un générateur (20) apte à générer sur une sortie un signal électrique discret pouvant uniquement prendre, à un instant donné, un seul état stable parmi un ensemble discret d'états stables possibles, cet ensemble discret étant choisi dans le groupe constitué d'un ensemble discret de plusieurs tensions stables et d'un ensemble discret de plusieurs intensités stables de courant, cet ensemble discret d'états stables possibles comportant un premier et un second états stables prédéterminés,
- un module (22 ; 120) d'auto-diagnostic apte à générer un signal d'erreur signalant une défaillance, ce module d'auto-diagnostic étant apte :
- à générer ce signal d'erreur en étant uniquement connecté à la sortie du générateur, et
- à déclencher une minuterie en réponse au passage du signal électrique discret du premier état stable à un autre état, cette minuterie décomptant un intervalle de temps prédéterminé à partir du moment où elle est déclenchée,
**caractérisé en ce que** :
- le module (22 ; 120) d'auto-diagnostic est également apte :
- à l'instant où l'intervalle de temps décompté par la minuterie s'est écoulé, à comparer l'état actuel du signal électrique discret au premier état stable, et
- si l'état actuel est égal au premier état stable, à déclencher la génération du signal d'erreur et, en alternance, si l'état actuel est différent du premier état stable, à inhiber ce déclenchement du signal d'erreur, et
- l'ensemble comporte aussi un système électronique (56) de traitement de signaux apte, en exploitant le signal d'erreur généré par le module d'auto-diagnostic, à indiquer à un opérateur de maintenance que le générateur présente des signes avant-coureurs de défaillance.

2. Ensemble selon la revendication 1, dans lequel le dispositif électronique comporte :
- un premier étage (24) d'alimentation du générateur apte à générer, à partir d'une différence de potentiels, la tension et le courant nécessaires au fonctionnement du générateur, et
- un second étage (26) d'alimentation du module d'auto-diagnostic apte à générer, à partir de la même différence de potentiels, la tension et le courant nécessaires au fonctionnement du module d'auto-diagnostic, ce second étage d'alimentation étant distinct et indépendant du premier étage d'alimentation.

3. Ensemble selon l'une quelconque des revendications précédentes, dans lequel le générateur (20) est un détecteur d'une grandeur physique et le signal électrique discret :
- prend le premier état stable lorsque la grandeur physique franchit, dans un sens, un premier seuil prédéterminé, et en alternance
- prend le second état stable lorsque la grandeur physique franchit, en sens opposé, un second seuil prédéterminé.

4. Ensemble selon l'une quelconque des revendications précédentes, dans lequel l'ensemble discret de plusieurs états stables possibles comprend uniquement le premier et le second états stables.

5. Ensemble selon l'une quelconque des revendications précédentes, dans lequel le dispositif comprend un même boîtier (50) à l'intérieur duquel sont logés le générateur et le module d'auto-diagnostic.

6. Ensemble selon l'une quelconque des revendications précédentes, dans lequel le module d'auto-diagnostic comprend :
- une bascule monostable (U3.1, U3.2) comportant une entrée et une sortie (Q) par laquelle est émis un signal d'horloge, l'entrée étant raccordée à la sortie du générateur de manière à recevoir un front montant ou descendant à chaque fois que le signal électrique discret généré par le générateur passe du premier état stable à l'autre état, cette bascule étant apte à générer sur sa sortie, en réponse au front montant ou descendant reçu sur son entrée, un front montant ou descendant dans le signal d'horloge à l'instant où l'intervalle de temps décompté par la minuterie s'est écoulé, cette bascule monostable formant ainsi ladite minuterie, et
- une bascule JK (U4.1, U4.2) comportant :
• une première entrée raccordée à la sortie du générateur de manière à recevoir un signal électrique représentatif de l'état actuel du signal électrique discret généré par le générateur,
• une deuxième entrée raccordée en permanence à un signal électrique représentatif du premier état stable,
• une troisième entrée raccordée à la sortie de la bascule monostable (U3.1, U3.2) pour recevoir le signal d'horloge,
• une sortie (70) générant le signal d'erreur,
cette bascule JK étant apte :
- en réponse audit front montant ou descendant dans le signal d'horloge, à comparer les états actuels des signaux électriques reçus sur ses première et deuxième entrées, et
- si, à cet instant, les états actuels des signaux électriques reçus sur les première et deuxième entrées sont égaux, à déclencher la génération du signal d'erreur sur sa sortie et, en alternance, si les états actuels des signaux électriques reçus sur les première et deuxième entrées sont différents, à inhiber ce déclenchement du signal d'erreur.

7. Module d'auto-diagnostic (22 ; 120) pour un ensemble conforme à l'une quelconque des revendications précédentes,dans lequel le module d'auto-diagnostic est apte à déclencher une minuterie en réponse au passage du signal électrique discret du premier état stable à un autre état, cette minuterie décomptant un intervalle de temps prédéterminé à partir du moment où elle est déclenchée,
**caractérisé en ce que** le module d'auto-diagnostic est aussi apte :
- à l'instant où l'intervalle de temps décompté par la minuterie s'est écoulé, à comparer l'état actuel du signal électrique discret au premier état stable, et
- si l'état actuel est égal au premier état stable, à déclencher la génération du signal d'erreur et, en alternance, si l'état actuel est différent du premier état stable, à inhiber ce déclenchement du signal d'erreur.

8. Procédé d'auto-diagnostic d'un dispositif électronique, ce dispositif électronique comportant un générateur apte à générer sur une sortie un signal électrique discret pouvant uniquement prendre, à un instant donné, un seul état stable parmi un ensemble discret d'états stables possibles, cet ensemble discret étant choisi dans le groupe constitué d'un ensemble discret de plusieurs tensions stables et d'un ensemble discret de plusieurs intensités stables de courant, cet ensemble discret d'états stables possibles comportant un premier et un second états stables prédéterminés, ce procédé comportant le déclenchement (84, 90) d'une minuterie en réponse au passage du signal électrique discret du premier état stable à un autre état, cette minuterie décomptant un intervalle de temps prédéterminé à partir du moment où elle est déclenchée,
**caractérisé en ce que** ce procédé comporte également les étapes suivantes :
- à l'instant où l'intervalle de temps décompté par la minuterie s'est écoulé, la comparaison (86, 92) de l'état actuel du signal électrique discret au premier état stable, et si l'état actuel est égal au premier état stable, le déclenchement (88, 94) de la génération du signal d'erreur et, en alternance, si l'état actuel est différent du premier état stable, l'inhibition de ce déclenchement du signal d'erreur, et
- un système électronique (56) de traitement de signaux indique, en exploitant le signal d'erreur généré par le module d'auto-diagnostic, à un opérateur de maintenance que le générateur présente des signes avant-coureurs de défaillance.

9. Support (124) d'enregistrement d'informations lisible par un microprocesseur, **caractérisé en ce que** ce support d'enregistrement d'informations comporte des instructions pour l'exécution d'un procédé conforme à la revendication 8, lorsque ces instructions sont exécutées par le microprocesseur.

## Patentansprüche

1. Set bestehend aus :
- eine elektronische Vorrichtung, die mit einer Selbstdiagnosefunktion ausgestattet ist, wobei diese Vorrichtung umfasst:
- einen Generator (20), der geeignet ist, an einem Ausgang ein diskretes elektrisches Signal zu erzeugen, das zu einem gegebenen Zeitpunkt nur einen einzigen stabilen Zustand aus einer diskreten Menge möglicher stabiler Zustände annehmen kann, wobei diese diskrete Menge aus der Gruppe ausgewählt wird, die aus einer diskreten Menge mehrerer stabiler Spannungen und einer diskreten Menge mehrerer stabiler Stromstärken besteht, wobei diese diskrete Menge möglicher stabiler Zustände einen ersten und einen zweiten vorbestimmten stabilen Zustand umfasst,
- ein Modul (22; 120) zur Selbstdiagnose, das in der Lage ist, ein Fehlersignal zu erzeugen, das einen Fehler signalisiert, wobei dieses Selbstdiagnosemodul in der Lage ist :
- dieses Fehlersignal zu erzeugen, indem er nur mit dem Ausgang des Generators verbunden ist, und
- einen Zeitgeber in Reaktion auf den Übergang des diskreten elektrischen Signals von dem ersten stabilen Zustand in einen anderen Zustand auszulösen, wobei der Zeitgeber ein vorbestimmtes Zeitintervall ab dem Zeitpunkt seiner Auslösung abzählt,
**dadurch gekennzeichnet, dass** :
- das Selbstdiagnosemodul (22; 120) auch in der Lage ist:
- zu dem Zeitpunkt, an dem das vom Timer gezählte Zeitintervall abgelaufen ist, den aktuellen Zustand des diskreten elektrischen Signals mit dem ersten stabilen Zustand zu vergleichen, und
- wenn der aktuelle Zustand gleich dem ersten stabilen Zustand ist, die Erzeugung des Fehlersignals auszulösen und abwechselnd, wenn der aktuelle Zustand sich vom ersten stabilen Zustand unterscheidet, diese Auslösung des Fehlersignals zu hemmen, und
- die Baugruppe auch ein elektronisches Signalverarbeitungssystem (56) umfasst, das durch Auswertung des vom Selbstdiagnosemodul erzeugten Fehlersignals in der Lage ist, einem Wartungstechniker mitzuteilen, dass der Generator Vorzeichen eines Ausfalls aufweist.

2. Anordnung nach Anspruch 1, wobei die elektronische Vorrichtung umfasst:
- eine erste Stufe (24) zur Versorgung des Generators, die geeignet ist, ausgehend von einer Potenzialdifferenz die Spannung und den Strom zu erzeugen, die für den Betrieb des Generators erforderlich sind, und
- eine zweite Stufe (26) zur Versorgung des Selbstdiagnosemoduls, die geeignet ist, ausgehend von der gleichen Potenzialdifferenz die Spannung und den Strom zu erzeugen, die für den Betrieb des Selbstdiagnosemoduls erforderlich sind, wobei diese zweite Versorgungsstufe von der ersten Versorgungsstufe getrennt und unabhängig ist.

3. Anordnung nach einem der vorhergehenden Ansprüche, wobei der Generator (20) ein Detektor für eine physikalische Größe und das diskrete elektrische Signal ist :
- den ersten stabilen Zustand einnimmt, wenn die physikalische Größe in einer Richtung einen ersten vorbestimmten Schwellenwert überschreitet, und abwechselnd
- den zweiten stabilen Zustand einnimmt, wenn die physikalische Größe in entgegengesetzter Richtung einen zweiten vorbestimmten Schwellenwert überschreitet.

4. Anordnung nach einem der vorhergehenden Ansprüche, wobei die diskrete Menge mehrerer möglicher stabiler Zustände nur den ersten und den zweiten stabilen Zustand umfasst.

5. Anordnung nach einem der vorhergehenden Ansprüche, wobei die Vorrichtung ein und dasselbe Gehäuse (50) umfasst, in dem der Generator und das Selbstdiagnosemodul untergebracht sind.

6. Anordnung nach einem der vorhergehenden Ansprüche, wobei das Selbstdiagnosemodul umfasst:
- ein monostabiles Flip-Flop (U3.1, U3.2) mit einem Eingang und einem Ausgang (Q), über den ein Taktsignal ausgegeben wird, wobei der Eingang so mit dem Ausgang des Generators verbunden ist, dass er jedes Mal, wenn das vom Generator erzeugte diskrete elektrische Signal vom ersten stabilen Zustand in den anderen Zustand übergeht, eine ansteigende oder abfallende Flanke empfängt, wobei dieses Flipflop geeignet ist, an seinem Ausgang in Reaktion auf die an seinem Eingang empfangene steigende oder fallende Flanke eine steigende oder fallende Flanke im Taktsignal in dem Moment zu erzeugen, in dem das vom Zeitgeber gezählte Zeitintervall abgelaufen ist, wobei dieses monostabile Flipflop somit den Zeitgeber bildet, und
- eine JK-Wippe (U4.1, U4.2) mit :
• einen ersten Eingang, der mit dem Ausgang des Generators verbunden ist, um ein elektrisches Signal zu empfangen, das für den aktuellen Zustand des vom Generator erzeugten diskreten elektrischen Signals repräsentativ ist,
• einen zweiten Eingang, der permanent mit einem elektrischen Signal verbunden ist, das für den ersten stabilen Zustand repräsentativ ist,
• einen dritten Eingang, der mit dem Ausgang des monostabilen Flipflops (U3.1, U3.2) verbunden ist, um das Taktsignal zu empfangen,
• einen Ausgang (70), der das Fehlersignal erzeugt,
wobei diese Wippe JK geeignet ist :
- in Reaktion auf die genannte steigende oder fallende Flanke im Taktsignal die aktuellen Zustände der an seinem ersten und zweiten Eingang empfangenen elektrischen Signale zu vergleichen, und
- wenn zu diesem Zeitpunkt die aktuellen Zustände der am ersten und zweiten Eingang empfangenen elektrischen Signale gleich sind, die Erzeugung des Fehlersignals an seinem Ausgang auszulösen und alternativ, wenn die aktuellen Zustände der am ersten und zweiten Eingang empfangenen elektrischen Signale unterschiedlich sind, diese Auslösung des Fehlersignals zu hemmen.

7. Selbstdiagnosemodul (22; 120) für eine Anordnung nach einem der vorhergehenden Ansprüche,wobei das Selbstdiagnosemodul geeignet ist, einen Timer als Reaktion auf den Übergang des diskreten elektrischen Signals von dem ersten stabilen Zustand in einen anderen Zustand auszulösen, wobei der Timer ein vorbestimmtes Zeitintervall ab dem Zeitpunkt seiner Auslösung herunterzählt, **dadurch gekennzeichnet, dass** das Selbstdiagnosemodul auch in der Lage ist:
- zu dem Zeitpunkt, an dem das vom Timer gezählte Zeitintervall abgelaufen ist, den aktuellen Zustand des diskreten elektrischen Signals mit dem ersten stabilen Zustand zu vergleichen, und
- wenn der aktuelle Zustand gleich dem ersten stabilen Zustand ist, die Erzeugung des Fehlersignals auszulösen und abwechselnd, wenn der aktuelle Zustand sich vom ersten stabilen Zustand unterscheidet, diese Auslösung des Fehlersignals zu hemmen.

8. Verfahren zur Selbstdiagnose einer elektronischen Vorrichtung, wobei diese elektronische Vorrichtung einen Generator umfasst, der an einem Ausgang ein diskretes elektrisches Signal erzeugen kann, das zu einem gegebenen Zeitpunkt nur einen einzigen stabilen Zustand aus einer diskreten Menge möglicher stabiler Zustände annehmen kann, wobei diese diskrete Menge aus der Gruppe ausgewählt wird, die aus einer diskreten Menge mehrerer stabiler Spannungen und einer diskreten Menge mehrerer stabiler Stromintensitäten besteht, wobei die diskrete Menge möglicher stabiler Zustände einen ersten und einen zweiten vorbestimmten stabilen Zustand umfasst, wobei das Verfahren das Auslösen (84, 90) eines Zeitgebers als Reaktion auf den Übergang des diskreten elektrischen Signals von dem ersten stabilen Zustand in einen anderen Zustand umfasst, wobei der Zeitgeber ein vorbestimmtes Zeitintervall ab dem Zeitpunkt des Auslösens herunterzählt,
**dadurch gekennzeichnet, dass** das Verfahren außerdem die folgenden Schritte umfasst:
- zu dem Zeitpunkt, zu dem das durch den Zeitgeber gezählte Zeitintervall abgelaufen ist, Vergleichen (86, 92) des aktuellen Zustands des diskreten elektrischen Signals mit dem ersten stabilen Zustand, und, wenn der aktuelle Zustand gleich dem ersten stabilen Zustand ist, Auslösen (88, 94) der Erzeugung des Fehlersignals und alternativ, wenn der aktuelle Zustand sich von dem ersten stabilen Zustand unterscheidet, Verhindern dieses Auslösens des Fehlersignals, und
- ein elektronisches Signalverarbeitungssystem (56) durch Auswertung des vom Selbstdiagnosemodul erzeugten Fehlersignals einem Wartungstechniker anzeigt, dass der Generator Vorzeichen eines Ausfalls aufweist.

9. Informationsaufzeichnungsmedium (124), das von einem Mikroprozessor gelesen werden kann, **dadurch gekennzeichnet, dass** das Informationsaufzeichnungsmedium Anweisungen für die Ausführung eines Verfahrens nach Anspruch 8 enthält, wenn diese Anweisungen von dem Mikroprozessor ausgeführt werden.

## Claims

1. Set comprising :
- an electronic device with a self-diagnosis function, this device comprising :
- a generator (20) adapted to generate at an output a discrete electrical signal that can only assume, at a given time, a single stable state from a discrete set of possible stable states, said discrete set being selected from the group consisting of a discrete set of a plurality of stable voltages and a discrete set of a plurality of stable current intensities, said discrete set of possible stable states including a first and a second predetermined stable state,
- a self-diagnosis module (22; 120) capable of generating an error signal indicating a failure, this self-diagnosis module being capable of :
- to generate this error signal by being connected only to the output of the generator, and
- triggering a timer in response to the discrete electrical signal changing from the first stable state to another state, the timer counting down a predetermined time interval from the time it is triggered,
**characterised in that** :
- the self-diagnosis module (22; 120) is also able to :
- at the time when the time interval counted by the timer has elapsed, comparing the current state of the discrete electrical signal with the first stable state, and
- if the current state is equal to the first stable state, triggering the generation of the error signal and, alternatively, if the current state is different from the first stable state, inhibiting this triggering of the error signal, and
- the assembly also comprises an electronic signal processing system (56) capable, by exploiting the error signal generated by the self-diagnosis module, of indicating to a maintenance operator that the generator is showing early signs of failure.

2. The assembly of claim 1, wherein the electronic device comprises :
- a first generator supply stage (24) capable of generating, from a potential difference, the voltage and current necessary for the operation of the generator, and
- a second power supply stage (26) for the self-diagnosis module capable of generating, from the same potential difference, the voltage and current necessary for the operation of the self-diagnosis module, this second power supply stage being distinct and independent from the first power supply stage.

3. An assembly according to any of the preceding claims, wherein the generator (20) is a detector of a physical quantity and the discrete electrical signal:
- assumes the first stable state when the physical quantity crosses, in one direction, a first predetermined threshold, and alternately
- assumes the second stable state when the physical quantity crosses a second predetermined threshold in the opposite direction.

4. The set according to any one of the preceding claims, wherein the discrete set of a plurality of possible stable states comprises only the first and second stable states.

5. An assembly according to any one of the preceding claims, wherein the device comprises a single housing (50) within which the generator and the self-diagnostic module are housed.

6. An assembly according to any of the preceding claims, wherein the self-diagnostic module comprises :
- a monostable flip-flop (U3.1, U3.2) having an input and an output (Q) through which a clock signal is emitted, the input being connected to the output of the generator in such a way as to receive a rising or falling edge each time the discrete electrical signal generated by the generator changes from the first stable state to the other state, said flip-flop being adapted to generate at its output, in response to the rising or falling edge received at its input, a rising or falling edge in the clock signal at the instant when the time interval counted by the timer has elapsed, said monostable flip-flop thus forming said timer, and
- a JK scale (U4.1, U4.2) comprising :
• a first input connected to the output of the generator so as to receive an electrical signal representative of the current state of the discrete electrical signal generated by the generator,
• a second input permanently connected to an electrical signal representative of the first stable state,
• a third input connected to the output of the monostable latch (U3.1, U3.2) to receive the clock signal,
• an output (70) generating the error signal,
this JK rocker being suitable for :
- in response to said rising or falling edge in the clock signal, to compare the current states of the electrical signals received at its first and second inputs, and
- if, at this time, the current states of the electrical signals received at the first and second inputs are equal, triggering the generation of the error signal at its output and, alternatively, if the current states of the electrical signals received at the first and second inputs are different, inhibiting this triggering of the error signal.

7. A self-diagnostic module (22; 120) for an assembly according to any one of the preceding claims,wherein the self-diagnostic module is adapted to trigger a timer in response to the discrete electrical signal changing from the first stable state to another state, said timer counting down a predetermined time interval from the time it is triggered,
**characterised in that** the self-diagnosis module is also capable of:
- at the time when the time interval counted by the timer has elapsed, comparing the current state of the discrete electrical signal with the first stable state, and
- if the current state is equal to the first stable state, to trigger the generation of the error signal and, alternatively, if the current state is different from the first stable state, to inhibit this triggering of the error signal.

8. A method of self-diagnosis of an electronic device, said electronic device including a generator adapted to generate at an output a discrete electrical signal capable of assuming, at a given time, only one stable state from a discrete set of possible stable states, said discrete set being selected from the group consisting of a discrete set of a plurality of stable voltages and a discrete set of a plurality of stable currents, said discrete set of possible stable states including first and second predetermined stable states, said method including triggering (84, 90) a timer in response to the discrete electrical signal changing from the first stable state to another state, said timer counting down a predetermined time interval from the time it is triggered,
**characterised in that** the method also comprises the following steps:
- at the time when the time interval counted by the timer has elapsed, comparing (86, 92) the current state of the discrete electrical signal with the first stable state, and if the current state is equal to the first stable state, triggering (88, 94) the generation of the error signal and, alternatively, if the current state is different from the first stable state, inhibiting this triggering of the error signal, and
- an electronic signal processing system (56) indicates to a maintenance operator, by evaluating the error signal generated by the self-diagnosis module, that the generator shows early signs of failure.

9. A microprocessor-readable information storage medium (124), **characterized in that** said information storage medium includes instructions for executing a method according to claim 8, when said instructions are executed by the microprocessor.
